# EUROPEAN PATENT APPLICATION

(11) **EP 0 869 352 A1**
(43) Date of publication of application: **07.10.1998**
(21) Application number: 98302579.2
(22) Date of filing: 01.04.1998
(51) Int. Cl.: G01N 21/88, H01L 21/66, G01R 31/308

(54) **Method for detecting metallic contaminants in submicron silicon surface layers of a semiconductor wafer**

(30) Priority: 03.04.1997 US 833024
(71) Applicant: Applied Materials, Inc., Santa Clara, California 95054 (US)
(72) Inventor: Lowell, John K., Road Rock, Texas (US)
(74) Representative: Bayliss, Geoffrey Cyril

(57) **Abstract**

Metallic contaminants in a submicron silicon surface layer of a semiconductor wafer (105) are detected by first applying a photon flux to the wafer (105) using a high-injection surface photovoltage technique over a range of frequencies to obtain a frequency dispersion plot of the wafer. First and second optical chopping frequencies are then selected from the frequency dispersion plot, and the semiconductor wafer (105) is again radiated with the photon flux at the first selected optical chopping frequency for generation of a surface barrier height map (400) showing a distribution of charges and values of such charges on the surface layer at the selected chopping frequency. The surface layer of the semiconductor wafer (105) is then radiated again with the photon flux at the second, different optical chopping frequency for generation of a second surface barrier height map (500) of the wafer. The wafer (105) is the annealed, and the process is repeated for generation of a frequency dispersion plot and surface barrier height maps (700, 800) for the annealed wafer. The frequency dispersion plots and surface barrier height maps (700, 800) generated for the annealed wafer are compared with the plots and maps (400, 500) generated for the un-annealed wafer in order to gauge the level of metal contaminants in the submicron surface layer of the wafer.

## Description

This invention relates to detection of contaminants in semiconductor wafers, and more particularly to a method for detecting metallic contaminants in submicron silicon surface layers of a semiconductor wafer.

In both very large scale integration (VLSI) and ultra large scale integration (ULSI), ionic contamination of semiconductor integrated circuits is a problem that seriously impacts their performance and reliability. One known method for alleviating this problem involves integrating shallow, or submicron, surface layers on silicon-on-insulator (SOI) or epitaxial silicon substrates. Using such substrates, it is expected that contaminant metals will be collected, or gettered, into the underlying Czochralski (CZ) layer and away from the surface where circuit devices are located. These surface layers may range in thickness from less than 1000Å to 2 µm.

While such schemes offer most technologies protection from metallic contamination, they are not totally infallible, and it is possible to collect amounts of contaminant metals such as iron, copper, aluminum, or nickel in the surface layer. Detection of metal contaminants in the submicron surface layer is important so that the level of contamination may be measured and controlled.

One known method for detection of metallic contaminants is secondary ion mass spectroscopy (SIMS). In this method, an ion beam is used to dislodge, or "sputter", material off a semiconductor surface. The ion component of the dislodged material is then detected and analyzed using a mass spectrometer. This method, however, suffers from various problems. One such problem is inadequate resolution. The metallic concentrations measured by SIMS are limited to a lower level, typically 10¹³ Atoms/cm³, which is much higher than the metallic contaminants to be detected in a submicron layer.

Another problem with the SIMS method is that it is destructive to the semiconductor wafer. Since SIMS requires an ion milling of the wafer substrate, it ruins the wafer from being used for either additional tests or product manufacture. Thus, it cannot be used in-line in a semiconductor wafer manufacturing process.

SIMS is also a time-consuming process. The time required to ion mill the substrate, detect the ion component of the dislodged material, and analyze the dislodged material can significantly reduce the overall time required for wafer development and optimization.

Finally, SIMS does not have the capability to analyze an entire wafer surface. SIMS focuses on localized areas, or points, of the wafer. Thus, in order to analyze an entire wafer surface, numerous points of the surface would each have to be separately analyzed. This would be both time-consuming and costly.

Another known method for detection of metallic contaminants utilizes low-injection surface photovoltage (SPV) and optical filtering to measure single-crystal substrates. While this method offers improvements over SIMS in resolution, and is non-destructive, it has a problem with depth measurement. Low-injection SPV measures from a depth of 10 µm to 130 µm, which is too deep for detecting contaminants in the ultra-thin, submicron silicon surface layers.

Accordingly, the present invention is a fast and simple method for detecting metallic contaminants in a submicron silicon surface layer of a semiconductor wafer. Such method provides adequate resolution and measures at depths sufficient for detection of contaminants in the ultra-thin, submicron silicon surface layers. The method of the present invention also quickly analyzes an entire wafer surface, and is non-destructive to the wafer surface. Furthermore, the method provides an indication of interfacial defects between the oxide and silicon layers of a semiconductor wafer.

In the method according to a preferred embodiment of the present invention, a frequency dispersion plot is first obtained showing the surface charge at the center of a semiconductor wafer as a function of the optical chopping frequency of a photon flux applied to the wafer surface. Such photon flux is applied using a high-injection surface photovoltage technique. A first optical chopping frequency is selected from the frequency dispersion plot approximately at a point where the corresponding surface charge is approximately constant for a plurality of successive chopping frequencies. The surface charge measurement at this first selected frequency is dominated by the silicon portion of the wafer and not by the oxide layer of the wafer and provides an indication of metallic contaminant activity near the silicon-oxide interface of the wafer. This point also provides a measurement which is functionally equivalent to a conventional C-V measurement for flatband voltage. A second optical chopping frequency is selected at a point higher than the first selected optical chopping frequency where the corresponding surface charge begins to deviate from being approximately constant. The surface charge measurement at this second selected frequency is dominated by the silicon-oxide or epitaxial-single crystal interface portion of the wafer. The surface charge deviation provides an indication that charges from metallic contaminants and other defects near the silicon-oxide interface are contributing to the total surface charge measurement.

The surface layer of the semiconductor wafer is then radiated with the photon flux at the first selected optical chopping frequency for generation of a surface barrier height map of the wafer showing a distribution of charges and values of such charges on the surface layer. The surface layer of the semiconductor wafer is again radiated with the photon flux at the second optical chopping frequency for generation of a second surface barrier height map of the wafer. These maps provide a picture of the pervasiveness of the metallic contaminant density across a layer of the wafer, the depth of the layer being determined by the optical chopping frequency chosen.

The semiconductor wafer is then ambient annealed at a low temperature to cause metal contaminants present within the submicron layer of the wafer to become interstitial and diffuse toward the wafer surface. An anneal temperature is selected at which only metals will diffuse so that any or all effects seen are unique to metals only. The charges of the added metal contaminants at the wafer surface in turn alter the surface barrier height of the wafer. The amount of surface barrier height enhancement is proportional to the concentration of contaminants. A frequency dispersion plot is again obtained, but this time for the annealed wafer. The surface layer of the annealed wafer is then radiated with the photon flux at the original first and second selected optical chopping frequencies, and surface barrier height maps of the semiconductor wafer are generated corresponding to the original, selected first and second chopping frequencies, respectively.

The level of concentration of metal contaminants in the submicron silicon surface layer of the semiconductor wafer can be easily and quickly gauged upon inspection and comparison of the differences in the frequency dispersion plots and surface barrier height maps for both the un-annealed and annealed wafer. The frequency dispersion plots provide a survey of vertical charge distribution between the surface and a buried interface of the wafer. From these plots, a picture of the metallic contaminant density on the surface, near the surface, and deeper may be obtained. The surface barrier height maps provide an indication of the pervasiveness of the metallic contaminants at a specific layer.

Figure 1 is a diagrammatic illustration of an apparatus suitable for the practice of the method according to the present invention.

Figure 2 is a flow chart illustrating the method of the present invention.

Figure 3 is a frequency dispersion plot taken at the wafer center before the wafer is annealed.

Figure 4 is a surface barrier height map of an un-annealed wafer after a surface photovoltage is applied at an optical chopping frequency of 281 Hz. according to the method of the present invention.

Figure 5 is a surface barrier height map of an un-annealed wafer after a surface photovoltage is applied at an optical chopping frequency of 7079 Hz. according to the method of the present invention.

Figure 6 is a frequency dispersion plot taken at the wafer center after the wafer is annealed.

Figure 7 is a surface barrier height map of an annealed wafer after a surface photovoltage is applied at an optical chopping frequency of 281 Hz. according to the method of the present invention.

Figure 8 is a surface barrier height map of an annealed wafer after a surface photovoltage is applied at an optical chopping frequency of 7079 Hz. according to the method of the present invention.

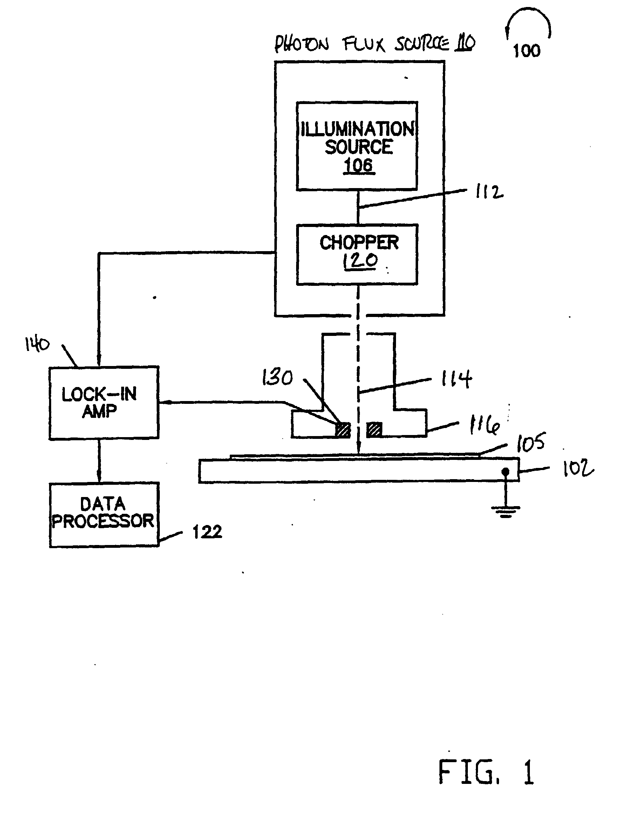

Referring now to the diagrammatic illustration of Figure 1, an apparatus suitable for the practice of the method according to one embodiment of the present invention is shown. Specifically, the apparatus 100 comprises an electrically grounded base plate 102 on which a semiconductor wafer 105 is placed during the detection method. A photon flux source 110 supplied a photon flux for application to the surface of the semiconductor wafer 105. The photon flux source includes an illumination source 106 and a rotating optical chopper 120. The optical chopper 120 modulates a beam of monochromatic light 112 produced by the illumination source 106 to create a train of monochromatic light pulses 114 with constant photon flux. The frequency at which the light pulses 114 are created is known as the "optical chopping frequency". In a preferred embodiment, the illumination source 106 is a semiconductor diode laser with a wavelength of 835mm. The train of monochromatic light pulses 114 passes through a housing 116 and strikes the surface of the semiconductor substrate 105 resting on the base plate 102. A pickup electrode 130 sends an electrical signal reflecting the level of the surface photovoltage of the semiconductor substrate 105 to a lock-in amplifier 140. The lock-in amplifier 140 is synchronized with the rotating chopper 120 via an electrical signal from the photon flux source 110. The lock-in amplifier 140 provides an output signal reflecting the resultant level of surface photovoltage produced by the semiconductor substrate 105 to data processor 122. Data processor 122 processes the input surface photovoltages produced at several different photon energy levels (i.e., wavelengths of incident light) to determine a surface barrier height of the semiconductor substrate 105. A description of how the surface photovoltage is produced is described in U.S. Patent No. 5,581,194 entitled "Method and Apparatus for Passive Optical Characterization of Semiconductor Substrates Subjected to High Energy (MEV) Ion Implantation Using High-Injection Surface Photovoltage", which is incorporated by reference herein in its entirety.

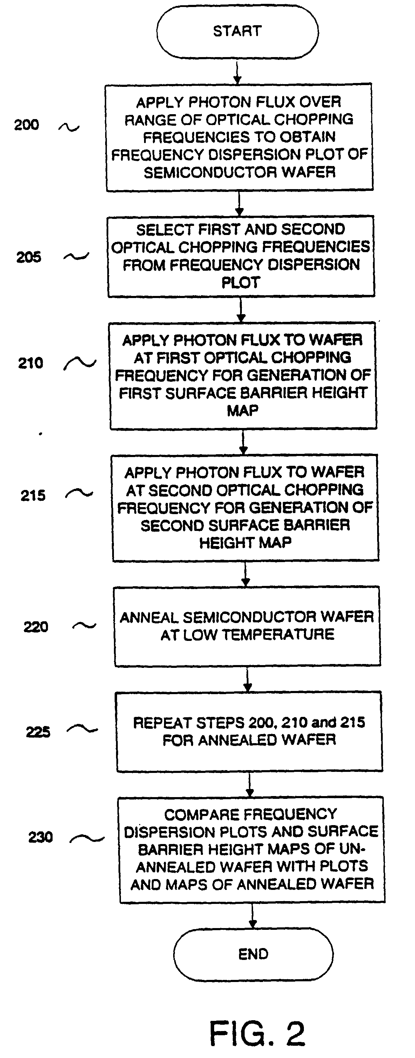

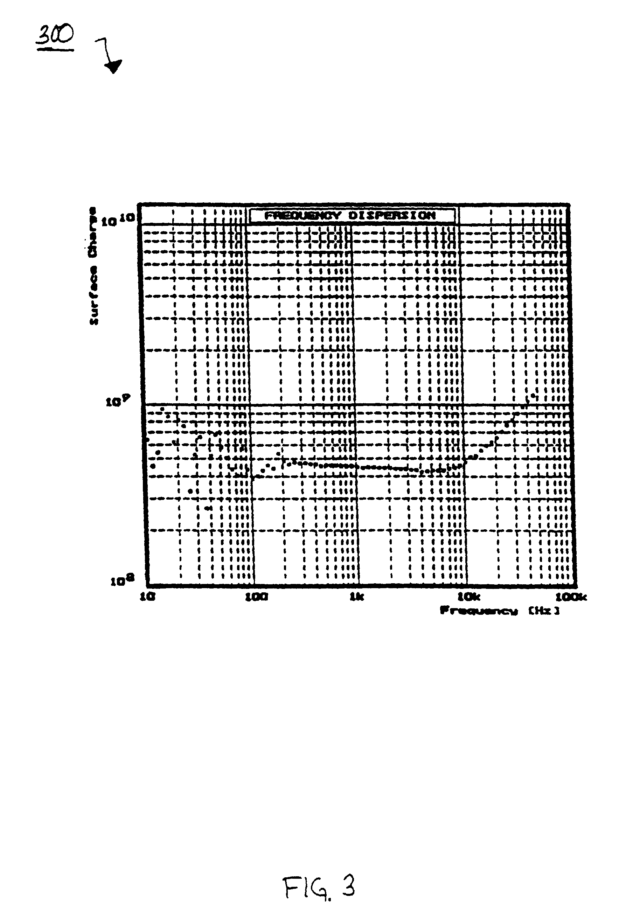

Referring now to Figure 2, there is shown a flowchart illustrating the preferred method. In order to detect metallic contaminants in a silicon layer of a semiconductor wafer 105, the photon flux is applied 200 to one point on the wafer 105, preferably at the center, over a full range of optical chopping frequencies to obtain a frequency dispersion plot of the wafer 105. A frequency dispersion plot displays the surface charge of the wafer 105, plotted on the Y-axis, as a function of the optical chopping frequency of the flux applied to the wafer 105 surface, plotted on the X-axis. An example of a frequency dispersion plot is shown in Figure 3. In a preferred embodiment, the range of frequencies at which the photon flux is applied is from 10 Hz to rolloff (approximately 50 KHz).

When a typical silicon-on-insulator (SOI) wafer 105 is illuminated by the photon flux, majority carriers (holes in P-type, electrons in N-type silicon) are applied to the wafer 105 temporarily saturating the wafer 105 surface. When the concentration of holes and electrons equalize, a flat-band condition analogous to that created by applying voltage to a metal-oxide-semiconductor (M-O-S) capacitor exists. This value is compared to a non-illuminated value of the charge. The difference is the extracted surface photovoltage which when put into a standard equation gives the surface charge or surface barrier value. At low optical chopping frequencies (below 100 Hz), the charge is dominated by surface effects. When the chopping frequency of the photon flux is between 100 Hz and 1000 Hz, the measurement is dominated by interface metallic contaminant defects which influence the space-charge region (SCR) or the portion below the SCR. The SCR is the minority carrier dominant area close to the surface formed by field reversal at high voltage or, in this case, applied light. When the chopping frequency is above 1000 Hz, defects below the interface, in the area called the "near-surface recombination zone", dominate the measurement. The depth of the SCR is about 100 angstroms for most wafers. Therefore, the near-surface region tells us about activity in the area below 100 angstroms. The frequency dispersion plot therefore provides a survey of vertical charge distribution between the surface and a buried interface of the wafer 105.

First and second optical chopping frequencies are then selected 205 from the frequency dispersion plot. The first optical chopping frequency is selected approximately at a point on the frequency dispersion plot where the corresponding surface charge is approximately constant for a plurality of successive optical chopping frequencies. At this point, surface charge measurement is dominated by the silicon portion of the wafer and not by the oxide layer of the wafer. This point further signifies the transition from surface effects dominating the surface charge measurement to interfacial effects dominating the measurement. This is also a useful point since it is functionally equivalent to a conventional C-V measurement for flatband voltage.

The second optical chopping frequency is selected at approximately a point where the corresponding surface charge begins to deviate from being approximately constant. The surface charge at this frequency is dominated by the silicon-oxide interface of the wafer. The surface charge typically begins to increase due to added charges from the oxide layer. These frequency values may vary among different wafers due to wafer doping dependencies. In general, wafers of both N and P-type silicon will have variances in doping or resistivity which parallel differences in size and technology application (e.g., memory, logic, etc.).

After the first and second optical chopping frequencies are selected 205, the photon flux is applied 210 to the semiconductor wafer 105 at the first selected frequency for generation of a surface barrier height map. A surface barrier height map indicates the values and distribution of charges on the wafer 105 at a specific chopping frequency. The photon flux is then applied 215 again to the semiconductor wafer 105 at the second selected optical chopping frequency for generation of a second surface barrier height map indicating the values and distribution of charges at the second selected frequency.

Next, the semiconductor wafer 105 is annealed 220 at a temperature below 700° C using a conventional ambient annealing process. Preferably, the anneal is for approximately 2 minutes at 200° - 250° C in ambient. This allows for the use of a common hot plate instead of more expensive and unwieldy equipment. The method steps described above-- applying 200 the photon flux over a full range of frequencies to obtain a new frequency dispersion plot, and applying 210, 215 the photon flux at the original first and second selected optical chopping frequencies for generation of third and fourth surface barrier height maps, respectively-- are then repeated 225 and performed on the annealed semiconductor wafer 105.

When subjected to the low temperature anneal, iron and other contaminant transition metals in the wafer 105 become interstitial and quickly diffuse throughout the wafer 105. When present in the ultra thin, submicron layer, the metal contaminants diffuse toward the wafer 105 surface, and charges on the metal contaminants alter the surface barrier height. The amount of change to the surface barrier height is proportional to the concentration of metal contaminants. Thus, the level of concentration of metal contaminants in the semiconductor wafer 105 may be determined by analyzing and comparing 230 the wafer surface charge measurements as shown by the frequency dispersion plots and surface barrier height maps generated for both the un-annealed and annealed wafer. From the frequency dispersion plot, a picture of the metallic contaminant density on the surface, near the surface, and deeper may be obtained. From the surface barrier height map, a picture of the pervasiveness of the defect density across a layer of the wafer may be obtained. Furthermore, since the anneal temperature of 700°C or below is unique to the diffusion of metals (the diffusion temperature of other defects such as oxygen or hydrogen is well above this temperature), any or all effects seen are unique to *metals only.*

The detection method of the present invention provides sufficient depth range measurement and adequate resolution (sensitivity at 10⁹ Atoms/cm³) for detection of metal contaminants in a submicron silicon surface layer. Further, the detection method is non-destructive to the silicon surface of the wafer 105 and can therefore be used in-line in a semiconductor manufacturing process. The detection method is also ideal for in-line usage since it is not unduly time-consuming.

In a preferred embodiment, a Surface Photovoltage Machine, model CMS/III-A, manufactured by Semiconductor Diagnostics, Inc., in Tampa, Florida, is utilized to obtain 200 the frequency dispersion plots, and to generate 210, 215 the surface barrier height maps. Preferably, the method described above is performed by a user manually adjusting the surface photovoltage machine to the appropriate optical chopping frequencies, and visually inspecting the generated frequency dispersion plots and surface barrier height maps to determine, respectively, the selected optical chopping frequencies and level of metal contaminants.

The following example further illustrates the method of the present invention. First, a wafer with a surface silicon layer of 1858 Å and an implanted oxygen layer of 779 Å is used as the semiconductor wafer 105. In Figure 3, there is shown a frequency dispersion plot 300 taken at the wafer 105 center. The frequency dispersion plot was generated using the CMS III-A surface photovoltage machine manufactured by Semiconductor, Diagnostics, Inc. The surface charge of the wafer 105 is plotted on the Y-axis as a function of the optical chopping frequency of the photon flux applied to the wafer 105 surface, which is plotted on the X-axis. The noisy portion at low optical chopping frequencies (approximately 10 Hz to 200 Hz) is due to the native oxide on the surface. However, the midrange and higher optical chopping frequencies show an approximately flat curve at 5x10⁸ /cm². In Figure 3, a frequency of 281 Hz. is selected as the first optical chopping frequency since it is approximately at a point where the corresponding surface charge is approximately constant for a plurality of successive optical chopping frequencies. A frequency of 7079 Hz is selected as the second optical chopping frequency since it is approximately at a point where the corresponding surface charge begins to deviate from being approximately constant.

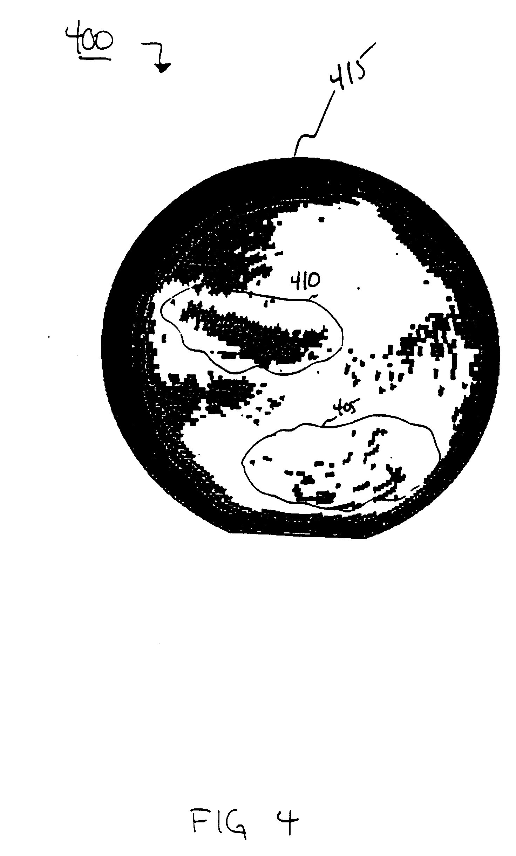

In Figures 4 and 5, there are shown surface barrier height maps 400, 500 for the first and second selected optical chopping frequencies of 281 Hz and 7079 Hz, respectively. The surface barrier height maps were also generated using the CMS III - a surface photovoltage machine manufactured by Semiconductor Diagnostics, Inc. The maps are shaded to indicate the surface charge value levels over the entire wafer 105 surface. In other words, the darker the shade, the greater the surface charge value. As can be seen by comparing Figures 4 and 5, the two maps 400, 500 show a distinct similarity in both surface charge value and distribution. Differences shown on the maps 400, 500 represent areas of more metallic contaminants. Although the values shown are very close, the two distinct areas at the flat 405, 505 and in the left-of-center 410, 510 can be seen. Also, the high surface charge around the outer ring 415 of the wafer indicates that the outer ring 400 has no buried oxide layer.

On SOI material, the initial (total) charge measured (@ 10 Hz) by the high-injection SPV is a sum of both the top Si charges and the charge at the Si-BOX (buried oxide) interface. As Figures 4 and 5 show, the contribution from the buried interface is negligible at low frequencies. However, the increased charge seen at the higher frequencies will be dominated by the BOX interfacial charge. In Figure 4, a large area of low charge can be seen on the wafer surface. However, if one "projects down into the silicon" using Figure 5, one can see that only in two areas is there direct mapping. In fact, one can see that in the left-of-center 410, 510 part of the wafer on both maps, the mapping is exact. The point here is that in these areas the charge is being dominated by activity below the SCR by the interstitial presence of metals. These cannot be oxygen precipitates since the anneal temperature is too low. Experiments with anneals up to 500 degrees C (anneal temp) show the same pattern every time. The large grey area on Figure 5 suggests when compared to the same area on Figure 4 that there is also a correspondence which can be interpreted as being influenced by metallic contaminants, but the presence of metallic contaminants is not as great.

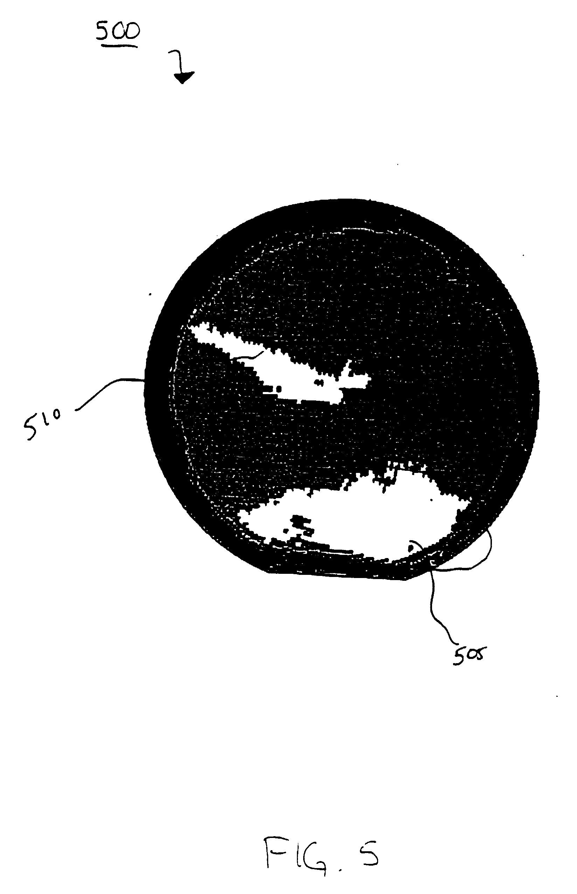

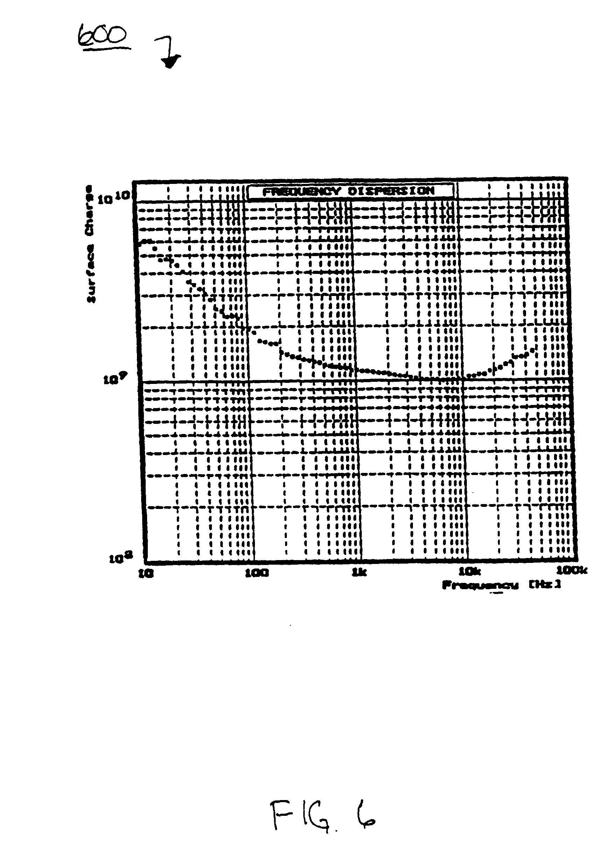

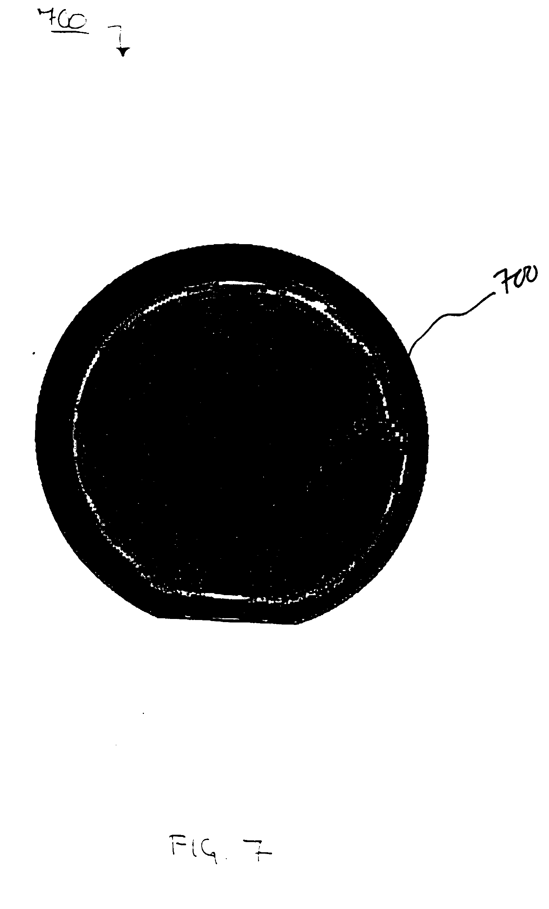

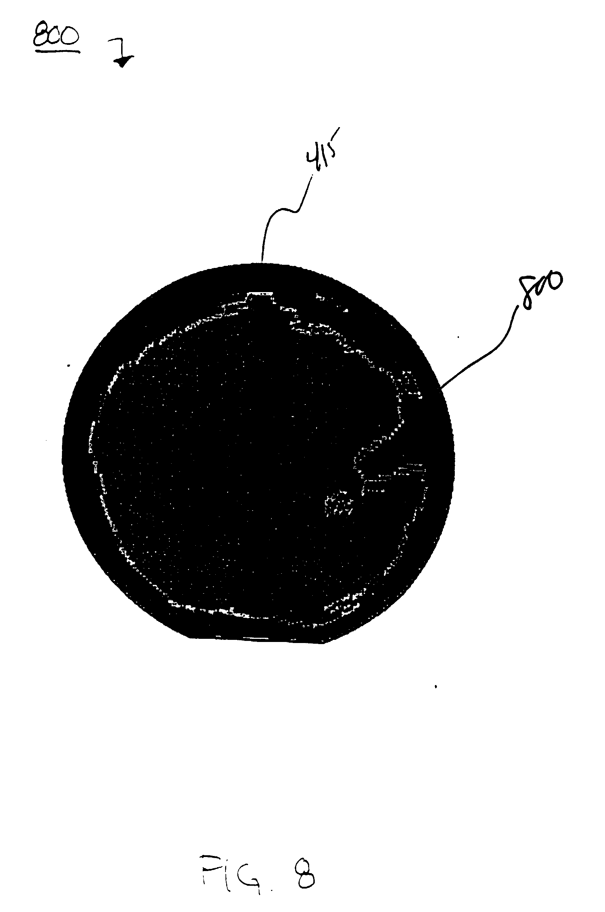

In Figure 6, the dispersion plot for the same wafer after the application of a low-temperature anneal is shown. After the anneal, the initial (total) charge (@10 Hz) has *increased* by an order of magnitude (6x10⁹/cm²⁾. Figures 7 and 8 show the surface barrier height maps 700, 800 of the annealed wafer 105 at the original first and second optical chopping frequencies of 281 Hz and 7079 Hz, respectively. Upon comparison to Figures 4 and 5, it can be seen that the wafer surface has changed considerably, becoming almost uniform in charge distribution. This behavior is consistent with what is known about the diffusion of metals in silicon. In this case, the Fe interstitial ions have been broken away from their FeB complex, for example, and due to the ultrashort vertical distance of the top layer have been collected within a range to which the SPC is sensitive. The uniformity of the wafer 105 maps shown in Figures 7 and 8 is a sign of the uniformity of metal (most likely Fe) concentration. Follow-up analysis using SIMS indicated an Fe concentration of 2x10¹¹ A/cm³ which is high enough to induce the shift in the dispersion plot shown in Figure 6. Of additional note is that the areas 405, 505 and 410, 510 on the wafer 105 that were clearly delineated before have disappeared, and only a small area on the extreme right side 700, 800 of the wafer 105 appears under these conditions. This is the only area where there is a difference in metallic concentration. It also shows an area where device yield degradation is likely to appear after subsequent processing. As can be seen in Figure 8, the small area on the extreme right side 800 shows the same surface charge values as the outer ring 415. This suggests that the oxide layer here could be non-existent and at least a possible area of low device yield. On a non-activated wafer, the charge is more likely to be from the top (silicon surface) to bottom (below the SCR) dominant. This means that the frequency dispersion plot will go from high-to-low in charge. On the activated sample, one sees the reverse, i.e., bottom-to-top pattern. This means that the difference between the charge at the surface and under the SCR is quite small (i.e., the surface is not contributing as much as the near surface region is to the measured charge). This difference is attributed to the metals.

The foregoing discussion discloses and describes merely exemplary methods and embodiments of the present invention. As will be understood by those familiar with the art, the invention may be embodied in other specific forms without departing from the spirit or essential characteristics thereof. Accordingly, the disclosure of the present invention is intended to be illustrative, but not limiting, of the scope of the invention, which is set forth in the following claims.

## Claims

1. A non-destructive method for detecting and gauging the level of metallic contaminants in a silicon layer of a semiconductor wafer comprising the steps of:
applying a photon flux to a point on the semiconductor wafer over a range of optical chopping frequencies for generation of a first frequency dispersion plot of the wafer, the plot indicating surface charge values of the wafer for the range of optical chopping frequencies;
annealing the semiconductor wafer at a low temperature;
applying the photon flux to a point on the annealed semiconductor wafer over the range of optical chopping frequencies for generation of a second frequency, dispersion plot of the annealed wafer, the plot indicating surface charge values of the annealed wafer for the range of optical chopping frequencies; and
comparing the first frequency dispersion plot with the second frequency dispersion plot in order to gauge the level of metallic contaminants in the silicon layer of the semiconductor wafer.

2. The method of claim 1 further comprising the steps of:
selecting a first optical chopping frequency approximately at a point on the first frequency dispersion plot where the corresponding surface charge is approximately constant for a plurality of successive optical chopping frequencies;
applying the photon flux to the un-annealed semiconductor wafer at the first selected optical chopping frequency for generating a first surface barrier height map of the wafer, the map indicating a first plurality of values and a first distribution of charges on a surface layer of the wafer at the first optical chopping frequency;
applying the photon flux to the annealed semiconductor wafer at the first selected optical chopping frequency for generating a second surface barrier height map of the annealed wafer; and
comparing the first surface barrier height map with the second surface barrier height map in order to gauge the level of metallic contaminants in the silicon layer of the semiconductor wafer.

3. The method of claim 2 further comprising the steps of:
selecting a second optical chopping frequency at a point on the first frequency dispersion plot higher than the first selected optical chopping frequency where the corresponding surface charge begins to deviate from being approximately constant;
applying the photon flux to the surface layer of the un-annealed semiconductor wafer at the second optical chopping frequency for generating a third surface barrier height map;
applying the photon flux to the surface layer of the annealed semiconductor wafer at the second optical chopping frequency for generating a fourth surface barrier height map of the annealed wafer; and
comparing the third surface barrier height map with the fourth surface barrier height map in order to gauge the level of metallic contaminants in the silicon layer of the semiconductor wafer.

4. The method of claim 1 wherein the silicon layer of the semiconductor is a submicron silicon surface layer.

5. The method of claim 1, wherein the low temperature is in the range of about 200°C to about 250°C.

6. The method of claim 1, wherein the photon flux is applied using a high-injection surface photovoltage technique.

7. The method of claim 1, wherein the photon flux wavelength is approximately 835 nanometers.

8. The method of claim 1, wherein the frequency range is from about 10 Hz to about 50 KHz.

9. The method of claim 1 wherein the point on the wafer where the photon flux is applied is the center of the wafer.
